# EUROPÄISCHE PATENTANMELDUNG

(11) **EP 3 614 506 A1**
(43) Veröffentlichungstag der Anmeldung: **26.02.2020**
(21) Anmeldenummer: 19203630.9
(22) Anmeldetag: 13.06.2018
(51) Int. Cl.: H01R 24/30, H01R 12/71, H01R 13/6592, H01R 13/6596, H01R 13/621, H01R 103/00, H01R 4/18, H01R 13/52, H01R 13/74

(54) **STEUERVORRICHTUNG FÜR EINEN KRAFTFAHRZEUG**

(30) Priorität: 14.06.2017 DE 102017210005
(62) Teilanmeldung aus: 18177443.1
(71) Anmelder: Eberspächer catem GmbH & Co. KG, 76863 Herxheim (DE)
(72) Erfinder: Inclán Garcia, Tobias, 67160 Wissembourg (FR); Deuschel, Nils, 67259 Heuchelheim (DE); Gschwind, Thomas, 67098 Bad Dürkheim (DE); Wambsganss, Timo, 76761 Rülzheim (DE)
(74) Vertreter: Grünecker Patent- und Rechtsanwälte PartG mbB

(57) **Zusammenfassung**

Die vorliegende Erfindung betrifft eine Steuervorrichtung in einem Kraftfahrzeug, insbesondere einer elektrischen Heizvorrichtung, mit einem Steuergehäuse (180), das eine Leiterplatte (186) umgibt, die mit weiblichen Steckkontaktelementen (198), bestückt ist, und einem dichtend an das Steuergehäuse (180) angelegten Kabeldurchführungsgehäuse (2, 102), das eine Anlagefläche (12, 112) und bevorzugt Befestigungsmittel (124) zur Befestigung des Durchführungsgehäuses (2, 102) an dem Steuergehäuse (180) aufweist und Aufnahmen (64; 144, 146) für zumindest zwei Kabel (46) aufweist, und mit von einer Vorderfläche (44) des Durchführungsgehäuses (2, 102) abragenden Kontaktelementen (34, 134), die zur Steckkontaktierung mit der Leiterplatte (186) angepasst ausgebildet und innerhalb des Durchführungsgehäuses (2, 102) mit den zugeordneten Kabeln (46) elektrisch verbunden sind, wobei die Kontaktelemente (34, 134) zum elektrischen Anschluss der Kabel (46) an die Leiterplatte (186) jeweils in einem der weiblichen Steckkontaktelemente (198) der Leiterplatte (186) aufgenommen sind, bei der zur Verringerung der Luft- und Kriechstrecke von der Vorderfläche (44) zumindest ein sich zwischen zwei Kontaktelementen (34, 134) erstreckender elektrisch isolierender Steg (48, 111) abragt und wobei die Leiterplatte (186) zwischen den weiblichen Steckkontaktelementen (198) eine korrespondierend zu dem Steg (48, 111) ausgebildete Stegaufnahme aufweist, in der der Steg (48, 111) aufgenommen ist.

## Beschreibung

Die vorliegende Erfindung betrifft eine Steuervorrichtung in einem Kraftfahrzeug, speziell eine Kabeldurchführung in ein eine Leiterplatte umgebendes Steuergehäuse der Steuervorrichtung. Die Kabeldurchführung hat in an sich bekannter Weise ein Durchführungsgehäuse, das eine Anlagefläche zur dichtenden Anlage an das Steuergehäuse und bevorzugt Befestigungsmittel zur Befestigung des Durchführungsgehäuses an dem Steuergehäuse aufweist. Des Weiteren bildet das Durchführungsgehäuse Aufnahmen für zumindest zwei Kabel aus, die elektrisch an die Leiterplatte anzuschließen sind.

Eine vorbekannte Kabeldurchführung hat üblicherweise ein aus Kunststoff oder einem anderen isolierenden Material gebildetes Durchführungsgehäuse, welches von Aufnahmen durchsetzt ist, die das Kabel von außen nach innen in das Steuergehäuse führen. Das Kabel ist innerhalb des Durchführungsgehäuses beim Stand der Technik teilweise um den Kabelmantel befreit, um beispielsweise eine Abschirmung des Kabels im Bereich des Durchführungsgehäuses freizulegen und diese elektrisch an von dem Durchführungsgehäuse gehaltene Abschirmkränze anzulegen, die das Kabel jeweils umfänglich umgeben. Das Durchführungsgehäuse hat üblicherweise eine in der Anlagefläche ausgesparte Nut, in die ein Dichtring eingesetzt ist. Den Aufnahmen ist üblicherweise eine Kabelabdichtung zugeordnet, sodass das Kabel in das Steuergehäuse abgedichtet eigebracht werden kann, um zu verhindern, dass Umwelteinflüsse, insbesondere Feuchtigkeit in das Steuergehäuse eindringen können. Das Durchführungsgehäuse weist ferner Befestigungsmittel üblicherweise in Form von Durchgangsbohrungen auf, mit denen das Durchführungsgehäuse an dem Steuergehäuse befestigt, speziell verschraubt werden kann.

Entsprechende Kabeldurchführungen sind insbesondere in der Automobiltechnik üblich und müssen dort den besonderen Bedingungen genügen, denen sämtliche Komponenten ausgesetzt sind, die in einem Fahrzeug verbaut sind. Hierzu gehören erhebliche Temperaturschwankungen, Vibrationsbelastungen sowie Schmutz und Feuchtigkeit in unmittelbarer Umgebung derjenigen Bauteile, die mit einer eigenständigen Steuerung versehen sind.

Die vorliegende Erfindung will insbesondere eine Steuervorrichtung mit einer Kabeldurchführung für eine elektrische Heizvorrichtung in einem Kraftfahrzeug angeben. Die vorliegende Erfindung hat dabei insbesondere das Problem im Blick, dass solche Komponenten mitunter auch in Elektrofahrzeugen eingebaut und dort mit Hochvoltspannung betrieben werden. In diesem Fall wird auf die Abschirmung besonderer Wert gelegt, um einen möglichst guten EMV-Schutz zu erhalten.

Bei den vorbekannten Kabeldurchführungen sind die Kabel im Inneren des Steuergehäuses abisoliert und mit Anschlussklemmen versehen, die durch Crimpen mit den Adern der jeweiligen Kabel verbunden sind. Diese Anschlussklemmen müssen in dem Steuergehäuse angeschlossen werden, was mit Montageaufwand verbunden ist. Die in dem Gehäuse verlegten Kabel können darüber hinaus bei nachfolgenden Montagevorgängen innerhalb des Steuergehäuses gequetscht werden, was zu Kabelbrüchen führen kann. Des Weiteren muss insbesondere bei Hochvolt-Anwendungen darauf geachtet werden, dass die elektrisch leitenden Teile der Kabel mit hinreichendem Abstand zu sonstigen Bauteilen verlegt werden. Auch sind Luft- und Kriechstrecken zu beachten, die verhindern sollen, dass Kriechstrom zwischen den verschiedenen Polaritäten fließt.

Diesen Anforderungen genügen die vorbekannten Durchführungen nicht hinlänglich.

Der vorliegenden Erfindung liegt das Problem zugrunde, eine verbesserte Steuervorrichtung mit einer Kabeldurchführung der eingangs genannten Art anzugeben. Dabei soll die erfindungsgemäße Lösung die Montage der Kabeldurchführung an dem Steuergehäuse erleichtern, wobei sowohl eine Erleichterung der Kontaktierung zwischen den einzelnen Kabeln und den Leitern der Leiterplatte wie auch eine leichtere Kontaktierung einer Abschirmung angegeben werden soll.

Zur Lösung dieses Problems wird mit der vorliegenden Erfindung eine Steuervorrichtung mit den Merkmalen von Anspruch 1 angegeben.

Diese ist gekennzeichnet durch Kontaktelemente, die von einer Vorderfläche des Durchführungsgehäuses abragen und zur Steckkontaktierung mit der Leiterplatte angepasst ausgebildet und innerhalb des Durchführungsgehäuses mit den zugeordneten Kabeln elektrisch verbunden sind. Die erfindungsgemäße Kabeldurchführung lässt sich dementsprechend von der Vorstellung leiten, dass über die Kabeldurchführung unmittelbar eine Steckkontaktierung zwischen den anzuschließenden Kabeln und der Leiterplatte erfolgen kann. Die Kontaktelemente sind dabei üblicherweise in zugeordneten weiblichen Steckkontaktelementen aufgenommen, die auf der Oberfläche der Leiterplatte montiert sein können oder aber innerhalb der Leiterplatte vorgesehen sind, wie dies in der EP 2 236 330 bzw. der EP 2 897 230 A1 beschrieben ist. Als Leiterplatte im Sinne der vorliegenden Erfindung wird jede plattenartige, d.h. ebene Struktur angesehen, die mit elektrisch leitenden Bahnen versehen ist. Die Leiterplatte kann mit Bauelementen bestückt sein. Sie kann aber auch ohne entsprechende Bauelemente versehen und lediglich zur Gruppierung von Heizkreisen bzw. der Leitung von Steuerstrom und Leistungsstrom in einer Ebene des Steuergehäuses angepasst ausgebildet sein. Als Leiterplatte im Sinne der vorliegenden Erfindung kann auch eine Leiterplatte angesehen werden, wie sie in EP 2 505 931 A1 beschrieben ist. Eine solche Leiterplatte besteht im Grunde aus mehreren Stromschienen, die in einem isolierenden Rahmen gehalten sind. Auch bei dieser Ausgestaltung werden die weiblichen Steckkontaktelemente üblicherweise unmittelbar durch Stanzen und Biegen derjenigen Blechstreifen erzeugt, die die leitenden Bahnen der Leiterbahn ausformen.

Es versteht sich, dass das Durchführungsgehäuse auch bei der erfindungsgemäßen Lösung bevorzugt mit dem Steuergehäuse verbunden ist. Auch hierzu weist das erfindungsgemäße Durchführungsgehäuse bevorzugt Bohrungen für eine Schraubverbindung zwischen dem Steuergehäuse und dem Durchführungsgehäuse auf.

Sind die weiblichen Steckkontaktelemente auf der Oberfläche der Leiterplatte montiert und überragen diese, so ist üblicherweise der Leiterplatte zugeordnet eine Gegenfläche vorgesehen, gegen welche die Vorderfläche des Durchführungsgehäuses anliegt, um diese relativ zu der Leiterplatte durch Anlage gegen dieselbe zu fixieren. Bevorzugt ist indes eine Ausgestaltung, bei welcher die Vorderfläche unmittelbar gegen die Leiterplatte anliegt, bei welcher demnach die weiblichen Steckkontaktelemente in der Ebene der Leiterplatte vorgesehen sind oder auf der der Kabeldurchführung rückwärtigen Seite der Leiterplatte. In diesem Fall kann die Oberfläche der Leiterplatte unmittelbar genutzt werden, um das Durchführungsgehäuse innerhalb des Steuergehäuses zu positionieren und zu halten.

Dementsprechend ist die Vorderfläche des Durchführungsgehäuses üblicherweise zur unmittelbaren Anlage an die Leiterplatte angepasst ausgebildet. Die Vorderfläche kann dementsprechend an die Kontur der Leiterplatte angepasste Konturen haben. Bevorzugt hat die Vorderfläche Formschlusselemente, die mit Formschlussgegenelementen der Leiterplatte zusammenwirken, um eine Poka-Yoke-Funktion zu bewirken, so dass das Durchführungsgehäuse nur in eindeutiger Weise relativ zu der Leiterplatte positioniert und die einzelnen Kontaktelemente mit den zugeordneten Kontaktgegenelementen der Leiterplatte kontaktiert werden können.

Die erfindungsgemäße Ausgestaltung bedingt üblicherweise, dass die Vorderfläche in Erstreckungsrichtung der Kabel mit Abstand zu der Anlagefläche vorgesehen ist, da üblicherweise die Leiterplatte mit Abstand zu einer Gehäusewand des Steuergehäuses angeordnet ist, die von der Kabeldurchführung durchsetzt und gegen welche die Kabeldurchführung montiert ist.

Die Vorderfläche des Durchführungsgehäuses ist bevorzugt mit Abstand zu einem Flansch vorgesehen, der gemäß einer bevorzugten Weiterbildung der vorliegenden Erfindung die Anlagefläche ausbildet und bevorzugt mit einer umlaufenden Nut versehen ist, die in der Anlagefläche ausgespart und in der ein Dichtring aufgenommen ist. Der Flansch kann dabei durch einen Teil des Durchführungsgehäuses gebildet sein, welches die Kontaktelemente hält. Der Flansch kann aber auch durch ein Durchführungsteil des Gehäuses gebildet sein, durch welches die Kabel abgedichtet hindurchgeführt werden und welches separat von einem Aufnahmeteil ausgebildet ist, welches die Kontaktelemente hält und die Vorderfläche ausbildet. Das Durchführungsteil kann dabei selbst aus einem elastischen Material gebildet sein, um eine möglichst gute Abdichtung des Kabels und/oder gegenüber der Gehäusewand des Steuergehäuses zu ermöglichen. Mitunter kann bei geeigneter stofflicher Beschaffenheit des Durchführungsteils auch auf einen separaten Dichtring verzichtet werden, insbesondere dann, wenn das Durchführungsteil aus einem weichelastischen Kunststoff gebildet ist. Das Durchführungsgehäuse ist üblicherweise vollständig als Kunststoffbauteil, insbesondere als Kunststoff-Spritzgussteil hergestellt.

Bevorzugt ragt von der Vorderfläche zumindest ein sich zwischen zwei Kontaktelementen erstreckender elektrisch isolierender Steg ab. Dieser ist üblicherweise einteilig an dem Durchführungsgehäuse angeformt. Der entsprechende Steg vergrößert die Kriechstrecke und verlegt eine Luftstrecke zwischen den von der Vorderfläche abragenden Kontaktelementen. Der Steg ist üblicherweise in einer korrespondierend hierzu vorgesehenen Stegaufnahme der Leiterplatte aufgenommen, wodurch auch im Bereich der Leiterplatte die Kriechstromstrecke zwischen den beiden Kontaktelementen erhöht wird. Diese Stegaufnahme wirkt als Formschlussgegenelement zu dem Steg und kann dementsprechend eine Poke-Yoke-Funktion haben. Bevorzugt ragen mehrere Stege von der Vorderfläche ab, die sich bevorzugt zwischen den jeweiligen Kontaktelementen erstrecken und neben der zuvor beschriebenen Funktion einer Erhöhung der Luft- und Kriechstrecken auch eine eindeutige räumliche Zuordnung des Durchführungsgehäuses relativ zu der Leiterplatte fordern, um elektrischen Kontakt zwischen den Kontaktelementen und den zugehörigen Leiterbahnen der Leiterplatte zu schaffen.

Wie bei dem Stand der Technik ist auch bei der erfindungsgemäßen Kabeldurchführung bevorzugt eine Kontaktierung zu einer Abschirmung des Kabels bzw. der Kabel gegeben. Diese Abschirmung ist regelmäßig durch ein Abschirmblech verwirklicht, das eine Abschirmfläche zur Kontaktierung einer gehäuseseitigen Abschirmung aufweist. Das Abschirmblech kontaktiert die Abschirmung des Kabels oder einer äußeren Abschirmung eines Kabelstranges, welches mehrere für sich isolierte Kabel in sich aufnimmt. Die Abschirmfläche dient der Kontaktierung mit einer gehäuseseitigen Abschirmung. Diese Kontaktierung kann beispielsweise durch unmittelbares Anlegen der Abschirmfläche des Abschirmbleches gegen eine Gegenfläche der gehäuseseitigen Abschirmung erfolgen. Die gehäuseseitige Abschirmung kann beispielsweise durch eine Oberfläche eines metallischen Steuergehäuses oder einer in das Steuergehäuse eingearbeiteten Abschirmung gebildet, die beispielsweise durch Umspritzen mit Kunststoff in einer Gehäusewand des Steuergehäuses eingebracht sein kann, indes im Bereich der Abschirmfläche freiliegt.

Bevorzugt hat das Abschirmblech zumindest zwei sich im Wesentlichen rechtwinklig zu der Abschirmfläche erstreckende Crimpstege, die mit den Kabeln verbunden sind. Die Verbindung zwischen dem Crimpsteg und dem entsprechenden Kabel kann eine mechanische und/oder eine elektrische Verbindung sein. Von dem Crimpsteg können mehrere Crimplaschen abragen, um einerseits eine Abschirmung des jeweiligen Kabels elektrisch zu kontaktieren und somit das Abschirmblech mit der Abschirmung des Kabels zu verbinden. Eine andere Crimplasche kann aber um den Kabelmantel gelegt sein, um lediglich das Kabel mechanisch mit dem Abschirmblech nach Art einer Zugentlastung zu verbinden.

Bei der hier diskutierten Weiterbildung ragen die Crimpstege im Wesentlichen rechtwinklig von der Abschirmfläche ab. Die Kabel durchsetzen dementsprechend im Wesentlichen rechtwinklig die Abschirmfläche, die zwischen den Kabeln und/oder außerhalb der Kabel vorgesehen sein kann. Die Abschirmfläche ist bevorzugt mit einer Bohrung versehen, die als Befestigungsaufnahme oder weibliche Steckelementaufnahme einer elektrischen Steckverbindung angepasst ausgebildet ist. Im Falle einer weiblichen Steckelementaufnahme kann beispielsw. die Verbindung zwischen dem Abschirmblech und einer steuergehäuseseitigen Abschirmung über eine Steckverbindung erfolgen, bei der ein männliches Steckelement in die Steckelementaufnahme der Abschirmfläche eingepasst ist. Ist die Bohrung als Befestigungsaufnahme vorgesehen, so wird üblicherweise das Abschirmblech mit seiner Abschirmfläche zwischen zwei Gehäuseteilen vorgesehen, welche das Zuführungsgehäuse ausbilden und das Abschirmblech auf diese Weise zwischen sich aufnehmen. Dabei kann die Bohrung von einem Klemmstift durchsetzt sein, der an einem der Gehäuseteile ausgebildet und mit dem anderen Gehäuseteil verbunden ist, beispielsweise durch Verkleben oder Warmverstemmen in einer an den Klemmstift im Grunde angepassten Aufnahme des anderen Gehäuseteils.

Die Befestigung der Kabel an den Crimpstegen, die eine vorbestimmte Ausrichtung zu der Abschirmfläche haben, dient einer Montageerleichterung. So können zunächst die Kabel mechanisch und/oder elektrisch mit den Crimpstegen verbunden werden. Aufgrund dieser Verbindung sind die Kabel und an den Kabelenden vorgesehene Kontaktelemente vorpositioniert. Beim Einbringen der Kontaktelemente in das Durchführungsgehäuse muss dementsprechend lediglich das Abschirmblech richtig positioniert werden, um sämtliche Kabel mit ihren entsprechenden Kontaktelementen in das Durchführungsgehäuse einzubringen und dort zu positionieren. Die Kontaktelemente haben zur Befestigung an dem Kabel in an sich bekannter Weise üblicherweise Crimplaschen, die an den Kabelmantel und/oder eine elektrisch leitende Ader des Kabels elektrisch leitend angeschlossen werden können. Darüber hinaus haben die Kontaktelemente üblicherweise eine Rastnase zur Verriegelung des Kontaktelementes in einer in dem Durchführungsgehäuse ausgesparten Steckkontaktaufnahme. So wird durch Einschieben des bzw. der Kontaktelemente das Kontaktelement und das zugehörige Kabel relativ zu dem Durchführungsgehäuse fixiert. Darüber hinaus ist nach Verriegeln der Kontaktelemente in dem Durchführungsgehäuse durch die Rastnasen die Beweglichkeit des Kontaktelementes in Längsrichtung des Kabels nur noch in Grenzen möglich, sodass das Steckkontaktieren des Durchführungsgehäuses gegen die Leiterplatte zuverlässig zu einer elektrischen Kontaktierung des jeweiligen Kontaktelementes mit der zugeordneten Leiterbahn der Leiterplatte führt.

Gemäß einer bevorzugten Weiterbildung der vorliegenden Erfindung ist ein dichtend mit einem Kabelmantel eines Kabels zusammenwirkendes Kabelabdichtelement vorgesehen, welches über eine einteilig an dem Crimpsteg ausgebildete Crimplasche mit dem Abschirmblech verbunden ist. Diese bevorzugte Ausgestaltung bietet die Möglichkeit, das Kabelabdichtelement zunächst über die Crimplasche mit dem Abschirmblech zu verbinden und zu positionieren. Nach diesem Zwischenmontageschritt mag das Durchführungsgehäuse bzw. ein Teil davon über das Kabel gezogen werden, um eine äußere gehäuseseitige Dichtfläche gegen das Kabelabdichtelement anzulegen, um das Kabel abgedichtet in das Durchführungsgehäuse einzuführen. Die Vorfixierung des Kabelabdichtelementes über die Crimplasche erleichtert auch diesen Montageschritt. Der hier diskutierte Aspekt kann auch für sich erfindungswesentlich sein. Eine erfindungsgemäße Kabeldurchführung weist die oberbegrifflichen Merkmale sowie ein Abschirmblech auf, welches eine Abschirmfläche zur Kontaktierung einer gehäuseseitigen Abschirmung und zumindest zwei sich im Wesentlichen rechtwinklig hierzu erstreckende Crimpstege aufweist, die mit den Kabeln verbunden sind und jeweils zumindest eine Crimplasche ausbilden, die das jeweilige Kabelabdichtelement mit dem Abschirmblech verbindet.

Wie bereits zuvor erwähnt, kann das Durchführungsgehäuse zweiteilig mit einem die Kontaktelemente haltenden Aufnahmeteil und einem die Kabel abdichtenden Durchführungsteil ausgebildet sein. Dabei ist das Abschirmblech zwischen dem Aufnahmeteil und dem Durchführungsteil gesichert, üblicherweise dazwischen geklemmt.

Die durch das Abschirmblech gebildete Abschirmfläche ist bevorzugt elektrisch leitend mit einer Kontaktierungsfläche verbunden, die an einer der Anlagefläche abgewandten Rückseite des Durchführungsgehäuses zum Anschluss an eine Abschirmung, insbesondere ein Schirmgeflecht freiliegt. Die Kontaktierungsfläche wird bevorzugt durch das Abschirmblech selbst ausgebildet. Bei dieser Ausgestaltung erstreckt sich üblicherweise die Kontaktierungsfläche zur Kontaktierung mit der Abschirmung rechtwinklig zu der Haupterstreckungsrichtung der Anlagefläche und ist durch Stanzen und Biegen aus einem die Abschirmfläche bildenden flachen Blechmaterial geformt. Regelmäßig bildet das Abschirmblech mehrere in solcher Weise vorbereitete Kontaktstege aus, die auf dem Umfang des Durchführungsgehäuses an dessen Rückseite verteilt vorgesehen sind, sodass ein an dieser Seite über das Durchführungsgehäuse gezogenes Schirmgeflecht beispielsweise durch einen Kabelbinder sowohl mechanisch mit dem Durchführungsgehäuse als auch elektrisch mit dem Abschirmblech verbunden werden kann. Die Abschirmung bzw. das Abschirmgeflecht liegt dabei üblicherweise an einer Rückseite eines Flansches an, der bevorzugt einteilig an dem Durchführungsgehäuse ausgebildet ist und mit seiner Vorderseite die Kontaktfläche des Abschirmblechs abstützt und an seiner Rückseite von dem bzw. den Kontaktstegen überragt ist. Ein den Flansch rückseitig überragender Teil des Durchführungsgehäuses wird bevorzugt durch einen Gehäusevorsprung gebildet. Am Außenumfang dieses Gehäusevorsprungs, der sich üblicherweise im Wesentlichen parallel zu der Erstreckungsrichtung der Kabel erstreckt, liegt der bzw. liegen die Kontaktstege frei. Der Gehäusevorsprung dient der Befestigung der Abschirmung bzw. des Schirmgeflechts.

Zur Vereinfachung der Herstellung der erfindungsgemäßen Kabeldurchführung wird gemäß einer bevorzugten Weiterbildung der vorliegenden Erfindung ein einteiliger Durchführungsgehäuse-Körper vorgeschlagen, der den Kontaktelementen zugeordnete, sich von der Vorder- bis zur Rückseite erstreckende Durchgänge aufweist. Diese Durchgänge bilden jeweils an der Vorderseite zur Aufnahme des Kontaktelementes angepasste Kontaktaufnahmen und an der Rückseite zur Aufnahme eines mit einem Mantel des Kabels zusammenwirkenden Kabelabdichtungselementes angepasste Abdichtungsaufnahmen aus. Das vordere Ende des Durchganges ist demnach in Form der Kontaktaufnahme ausgeformt, das hintere Ende in Form der Abdichtungsaufnahme. Bei dieser Ausgestaltung können beide Funktionalitäten des Durchführungsgehäuses, nämlich einerseits das Halten und Fixieren des Kontaktelementes und andererseits das Abdichten des Kabels in einem einzigen einheitlichen Durchführungsgehäuse-Körper vorgesehen sein. Mit diesem Durchführungsgehäuse-Körper ist bevorzugt eine Kappe verrastbar, die in die Abdichtungsaufnahme eingreifende Vorsprünge ausbildet. Die Vorsprünge sind üblicherweise als federnde Vorsprünge ausgebildet. Die Vorsprünge wirken mit dem in der Abdichtungsaufnahme aufgenommenen Kabelabdichtungselement zusammen und verpressen dieses Element innerhalb der entsprechenden Aufnahme, sodass sich eine gute Abdichtung des Kabels innerhalb des Durchführungsgehäuse-Körpers ergibt.

Weitere Einzelheiten und Vorteile der vorliegenden Erfindung ergeben sich aus der nachfolgenden Beschreibung von Ausführungsbeispielen in Verbindung mit der Zeichnung. In dieser zeigen:
- Figur 1: eine perspektivische Seitenansicht eines ersten Ausführungsbeispiels;
- Figur 2: eine Draufsicht auf die Vorderseite des ersten Ausführungsbeispiels;
- Figur 3: eine perspektivische Seitenansicht eines Abschirmelementes des ersten Ausführungsbeispiels;
- Figur 4: eine perspektivische Seitenansicht eines Kontaktelementes des ersten Ausführungsbeispiels;
- Figur 5: eine Längsschnittansicht des ersten Ausführungsbeispiels;
- Figuren 6a bis i: perspektivische Seitenansichten verschiedener Montageschritte bei der Herstellung des ersten Ausführungsbeispiels;
- Figur 7: eine perspektivische Seitenansicht eines zweiten Ausführungsbeispiels;
- Figur 8: eine perspektivische Draufsicht auf die Gehäusekappe des zweiten Ausführungsbeispiels;
- Figur 9: eine perspektivische Draufsicht auf den Durchführungsgehäuse-Köper des zweiten Ausführungsbeispiels;
- Figur 10: eine perspektivische Draufsicht auf das Abschirmblech des zweiten Ausführungsbeispiels;
- Figur 11: eine Draufsicht auf die Vorderseite des zweiten Ausführungsbeispiels;
- Figur 12: eine Längsschnittansicht des zweiten Ausführungsbeispiels entlang der Linie XII- XII gemäß Figur 11;
- Figuren 13a bis j: perspektivische Seitenansichten verschiedener Montageschritte bei der Herstellung des zweiten Ausführungsbeispiels und
- Figur 14: eine Schnittdarstellung entlang der Linie XIV - XIV gemäß der Darstellung in Figur 11 für eine Kabeldurchführung mit einem Steuergehäuseelement.

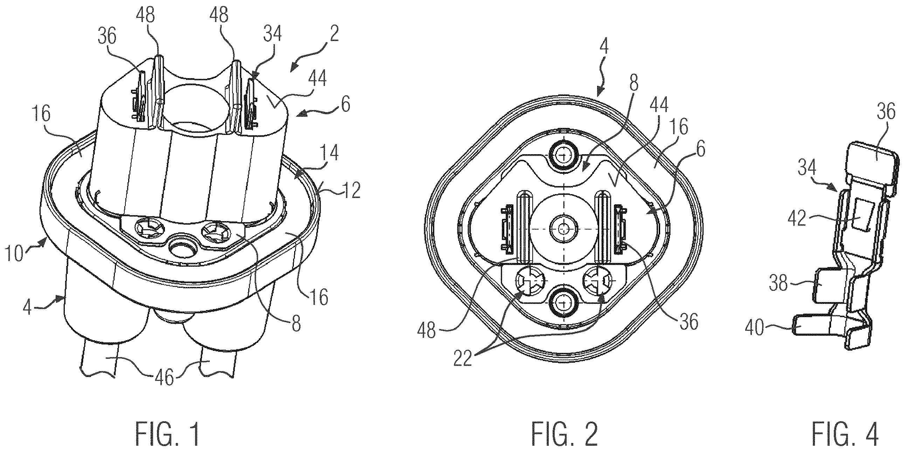

Die Figur 1 zeigt eine perspektivische Seitenansicht eines Ausführungsbeispiels eines Kabeldurchführungsgehäuses 2 für eine erfindungsgemäße Kabeldurchführung. Das Kabeldurchführungsgehäuse 2 ist vorliegend zweiteilig ausgebildet und hat ein Durchführungsteil 4 und ein Aufnahmeteil 6, die unter Zwischenlage eines Abschirmbleches 8 miteinander verbunden sind. Das Durchführungsteil 4 bildet einen Flansch 10 aus, der eine Anlagefläche 12 zur Anlage an ein nicht dargestelltes Steuergehäuse ausbildet. Die Anlagefläche 12 ist mit einer umlaufenden Nut 14 versehen, in welche ein Dichtring 16 eingesetzt ist.

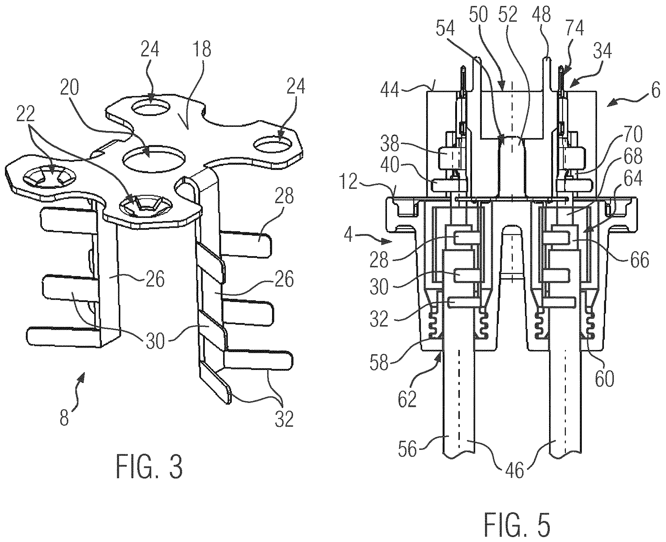

Das in Figur 3 perspektivisch gezeigte Abschirmblech 8 hat mehrere eine ebene Abschirmfläche 18 durchsetzende Bohrungen, von denen eine mittlere Bohrung mit Bezugszeichen 20 gekennzeichnet ist. Die mit Bezugszeichen 22 gekennzeichneten seitlichen Bohrungen sind als weibliche Steckelementaufnahmen ausgeformt. Die gegenüberliegend dazu vorgesehenen und mit Bezugszeichen 24 gekennzeichneten seitlichen Befestigungsbohrungen werden von Zapfen durchsetzt, die die Anlagefläche 12 durchsetzen und an dem Durchführungsteil 4 und/oder dem Aufnahmeteil 6 vorgesehen und in zugeordneten Bohrungen des jeweils anderen Teils eingepasst sind, um die beiden Teile 4, 6 relativ zueinander unter Einschluss des Abschirmbleches zu positionieren. Durch diese Formschlussverbindung kann auch eine Vorpositionierung des Abschirmbleches 8 relativ zu einem der Teile 4 oder 6 erfolgen, um das Abschirmblech 8 an einem der Teile 4, 6 vorzumontieren und danach die beiden Teile 4, 6 zu fügen.

Das Abschirmblech 8 bildet zwei sich im Wesentlichen rechtwinklig zu der Abschirmfläche 18 erstreckende Crimpstege 26 aus, die durch Stanzen und Biegen aus dem zunächst ebenen Material des Abschirmbleches 8 gebildet sind. Bei dieser Blechbearbeitung werden auch Crimplaschen ausgeformt, die rechtwinklig von den länglichen Crimpstegen 26 abgehen. Nachstehend wird auf die einzelnen Crimplaschen eingegangen, die zu diesem Zweck mit Bezugszeichen 28 (erste Crimplasche), 30 (zweite Crimplasche) und 32 (dritte Crimplasche) gekennzeichnet sind.

Mit Bezugszeichen 34 ist in Figur 4 ein männliches Kontaktelement dargestellt, welches an seinem vorderen Ende eine Kontaktzunge 36 ausformt. An dem der Kontaktzunge 36 gegenüberliegenden Ende hat das Kontaktelement 34 innere Crimplaschen 38 und äußere Crimplaschen 40. Zwischen diesem befestigungsseitigen Ende des Kontaktelementes 34 und der Kontaktzunge 36 ist durch Stanzen und Biegen eine Rastzunge 42 freigeschnitten und aus der Ebene des das Kontaktelement 24 bildenden Blechmaterials herausgebogen.

Die Figuren 1, 2 und 5 zeigen weitere Details des Ausführungsbeispiels. Ersichtlich überragen die Kontaktelemente 34 mit ihren freien Enden, d.h. den Kontaktzungen 36 eine Vorderfläche 44 des Aufnahmeteils 6 und bilden dementsprechend männliche Kontaktelemente zur Steckkontaktierung des Kabeldurchführungsgehäuses 2 an eine Leiterplatte aus. Zwischen den beiden Kontaktzungen 36 erstrecken sich in Längserstreckungsrichtung der Kontaktelemente 34 korrespondierend der Erstreckungsrichtung von Kabeln 46, die jeweils an die Kontaktelemente 34 angeschlossen sind, Stege 48, die einteilig an dem Aufnahmeteil 6 ausgebildet sind und in Längserstreckungsrichtung die Kontaktelemente 4 überragen (vgl. Figur 5). Zwischen diesen beiden Stegen 48 ist die Vorderfläche 44 von einer zentralen Bohrung 50 durchsetzt, in der ein Klemmstift 52 freiliegt, der einteilig an dem Durchführungsteil 4 vorgesehen ist und die Anlagefläche 12 durchragt. Der Klemmstift 52 sitzt in einer Klemmstiftaufnahme 54, die an dem Aufnahmeteil 6 ausgespart ist. Der Klemmstift 52 kann innerhalb dieser Klemmstiftaufnahme 54 aufgepresst oder verklebt sein. Ebenso kann der aus Kunststoff gebildete Klemmstift 52 durch Warmverstemmen in der Klemmstiftaufnahme 54 fixiert sein. Hierzu ist die Bohrung 50 wesentlich größer im Durchmesser als die Klemmstiftaufnahme 54 bzw. der Klemmstift 52.

An dem gegenüberliegenden Ende des Kabeldurchführungsgehäuses 2 befinden sich auf einem Mantel 56 der jeweiligen Kabel 46 elastomere Kabelabdichtelemente 58 mit einer äußeren Labyrinthdichtung. Der Innendurchmesser der Kabelabdichtelemente 58 ist auf den Außendurchmesser des Kabelmantels 56 angepasst. Im gefügten Zustand gemäß Fig. 5 liegt die Labyrinthdichtung, d.h. die mit Abstand vorgesehenen Dichtringe des Kabeldichtelementes 58 an einer äußeren Dichtfläche 60 an, die durch das Durchführungsteil 4 gebildet wird und benachbart zu einer Kabeldurchführungsöffnung 62 am hinteren Ende des Durchführungsteiles 4 vorgesehen ist. Die äußere Dichtfläche 60 ist in Richtung auf das Aufnahmeteil 6 konusförmig verbreitert und geht in einen Aufnahmeraum 64 für jeweils einen der Crimpstege 26 über. In diesem Aufnahmeraum 64 ist das Kabel 46 mit dem Abschirmblech 8 verbunden. Hierzu umschließen die zweiten Crimplaschen 30 das Kabel mit seinem Mantel 56 umfänglich. Die ersten Crimplaschen 28 liegen umfänglich an einer Kabelabschirmung 66 an, die durch Entfemen des Kabelmantels 56 freigelegt ist und in Längsrichtung des Kabels 46 von einem inneren Mantel 68 überragt wird, der eine elektrisch leitende Ader 70 des Kabels umgibt. Diese Ader 70 ist durch Crimpen mit der inneren Crimplasche 38 auch elektrisch verbunden. Die äußeren Crimplaschen 40 umschließen den inneren Mantel 68 zur mechanischen Verbindung und Zugentlastung zwischen dem Kontaktelement 34 und dem zugeordneten Kabel 46. Die paarweise vorgesehenen dritten Crimplaschen umschließen jeweils einen Hülsenabschnitt des Kabeldichtelementes 58, der der Labyrinthdichtung in axialer Richtung vorgelagert und einteilig an dem Kabeldichtelement 58 vorgesehen ist. Hierdurch wird das Kabeldichtelement 58 in axialer Richtung auf dem Kabelmantel 56 fixiert.

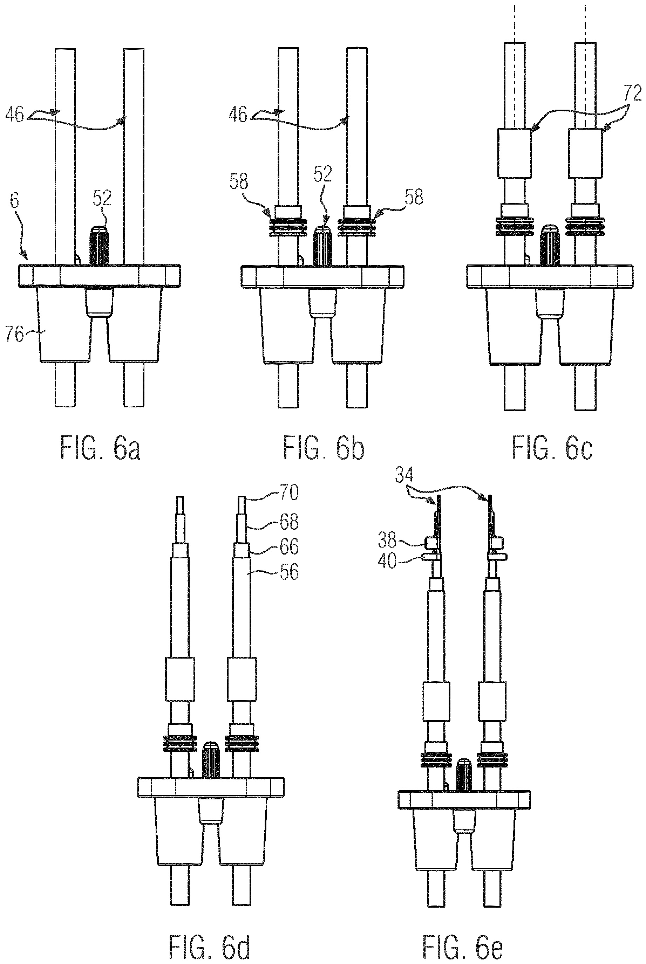

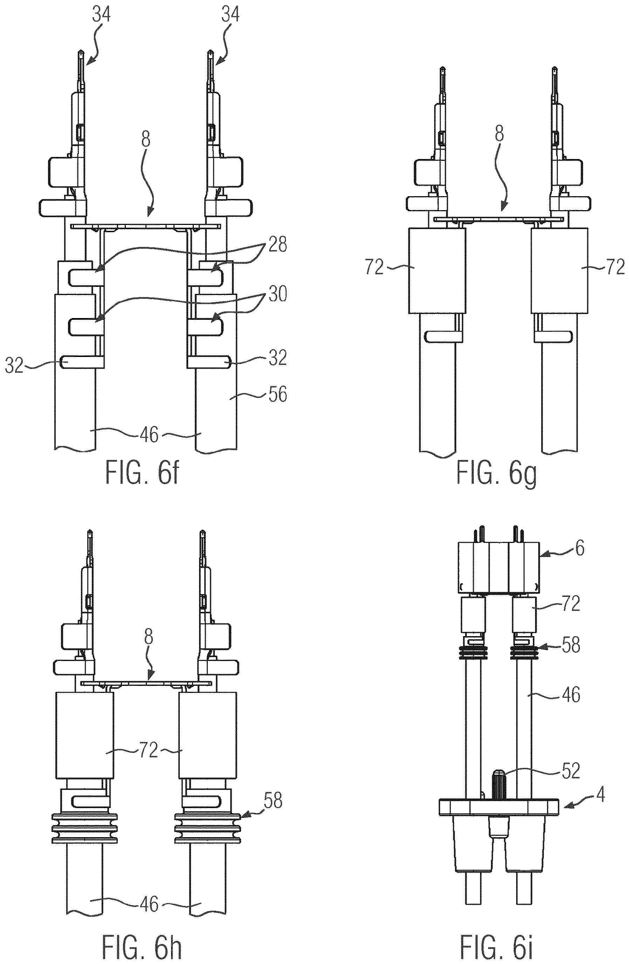

Nachstehend wird unter Bezugnahme auf die Figuren 6 a-j die Montage des Ausführungsbeispiels erläutert. Zunächst wird das Aufnahmeteil 6 über die Kabel 56 geschoben (Fig. 6a). Dann werden über das freie Ende der Kabel 46 jeweils die Kabeldichtelemente 58 geschoben (Fig. 6b). Danach werden mit Bezugszeichen 72 gekennzeichnete Schrumpfschlauchstücke jeweils von dem freien Ende über die Kabel 56 gezogen (Fig. 6c). Die freien Enden der Kabel 46 werden abisoliert, um einerseits die Kabelabschirmung 66 und mit axialem Abstand dazu die Ader 70 freizulegen (Fig. 6d).

Danach werden die jeweiligen Kontaktelemente 34 über die freien Enden der Kabel 46 geschoben und mit diesen durch Crimpen mechanisch und elektrisch verbunden. Diese Situation ist in Fig. 6e dargestellt. Aus Gründen einer einfacheren Darstellung sind die äußeren und inneren Crimplaschen 38, 40 weiterhin abragend dargestellt. Es versteht sich von selbst, dass am Ende der Montage sämtliche Crimplaschen an einem Umfangsabschnitt des zu verbindenden Kabels 46 anliegen.

Danach wird das Abschirmblech 8 mit den Kabeln 46 verbunden. Die zweite Crimplasche 30 wird als Zugentlastung gegen den Kabelmantel 56 gelegt, die erste Crimplasche 28 als Schirmanbindung gegen die Kabelabschirmung 66. Im Rahmen dieses Crimpens bleiben die dritten Crimplaschen 32 in ihrem Ausgangszustand (vgl. Fig. 6f).

Nun werden die Schrumpfschlauchstücke 72 bis an das die Abschirmfläche 18 bildende mittlere Stück des Abschirmbleches 8 geschoben und aufgeschrumpft. Danach überdeckt das Schrumpfschlauchstück 72 die ersten Crimplaschen 28 und die zweiten Crimplaschen 30 (Fig. 6g). Entlang der Kabel 46 werden nunmehr die Kabeldichtelemente 58 in Richtung auf das Abschirmblech 8 verschoben, bis die Labyrinthdichtung im Grunde gegen die dritten Crimplaschen 32 stoßen. Die dritten Crimplaschen 32 werden gecrimpt, um das Kabeldichtelement 58 axial auf dem Kabel 46 zu fixieren (Fig. 6h).

Aufgrund des Abschirmbleches 8 und der Positionierung durch die Crimpstege 26 sind die Kabel 46 und damit die Kontaktelemente 34 relativ zueinander vorpositioniert. So kann das Aufnahmeteil 6 nach einmaliger Positionierung relativ zu dem Abschirmblech 8 über die Kontaktelemente 34 geschoben werden, die hierbei in an dem Aufnahmeteil 6 ausgesparte Kontaktaufnahmen 74 eingebracht werden. Im Rahmen dieser Bewegung verrastet die Rastzunge 42 gegen eine Gegenfläche des Aufnahmeteiles 6, sodass die Kontaktelemente 34 und damit die Kabel 46 mit dem Aufnahmeteil 6 verbunden sind (Fig. 6i). Schließlich wird das Durchführungsteil 4 geführt von den Kabeln 46 gegen das Aufnahmeteil 6 geschoben und dagegen angelegt. Hierbei durchsetzt der Klemmstift 52 zunächst die mittlere Bohrung 20 des Abschirmbleches 8 und wird schließlich in der Klemmstiftaufnahme 54 des Aufnahmeteils 6 aufgenommen und dort in der zuvor beschriebenen Weise befestigt, beispielsweise durch Warmverstemmen (Fig. 6i, Fig. 5). Schließlich wird der Dichtring 16 in die Nut 14 eingelegt.

Bei dem fertigen Erzeugnis gemäß den Figuren 1, 3 und 5 befinden sich die weiblichen Steckelementaufnahmen 22 des Abschirmbleches 8 innerhalb des Dichtringes 16 und außerhalb einer Umfangsfläche, die durch das Aufnahmeteil 6 gebildet wird. Hierdurch kann die durch das Abschirmblech 8 gebildete Abschirmung des Kabeldurchführungsgehäuses 2, die mit der Kabelabschirmung 66 elektrisch leitend verbunden ist, innerhalb des Steuergehäuses oder an dem steckkontaktiert werden. Auch ist es möglich, Kontaktierungszapfen an der Au-βenseite des Steuergehäuses vorzusehen, die beim Aufsetzen des Durchführungsgehäuses 2 in die entsprechenden weiblichen Steckelementaufnahmen 22 eingreifen und damit elektrisch leitend verbunden werden.

In Erstreckungsrichtung der Stege 48 vor und hinter der Bohrung 50 sind in Figur 6a Vorbereitungen 76 zu erkennen, die an dem Durchführungsteil 4 vorgesehen sind, um neben den beiden für den Leistungsstrom vorgesehenen Kabeln 46 weitere Kabel, beispielsweise Kabel eines HV-Interlocks in dem Kabeldurchführungsgehäuse 2 nach innen in das Steuergehäuse zu führen. Auch diese HV-Interlockkabel sind vorzugsweise in Form von männlichen Steckelementen die Vorderfläche 44 eines abgewandelten Aufnahmeteils überragend vorgesehen und damit mittels Steckverbindung an die Leiterplatte anschließbar.

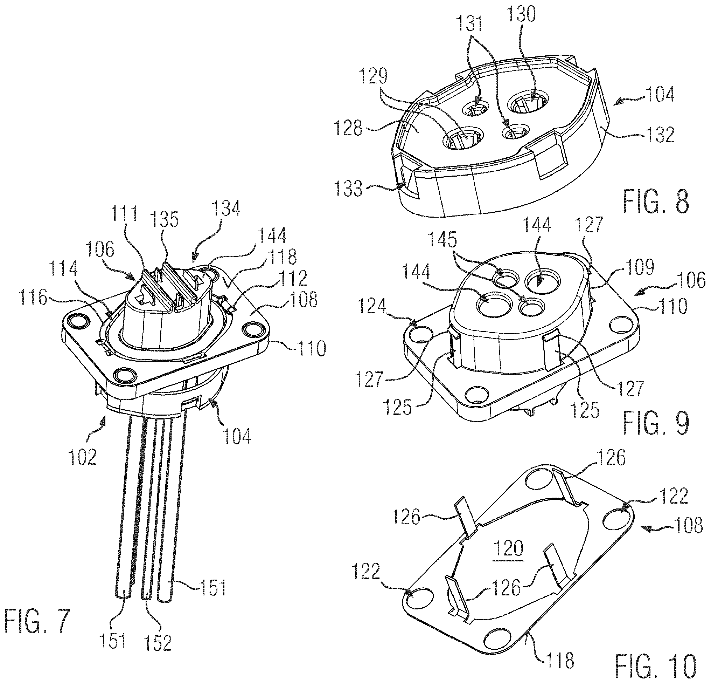

Das Ausführungsbeispiel nach den Fig. 7 ff. zeigt eine entsprechende Ausgestaltung.

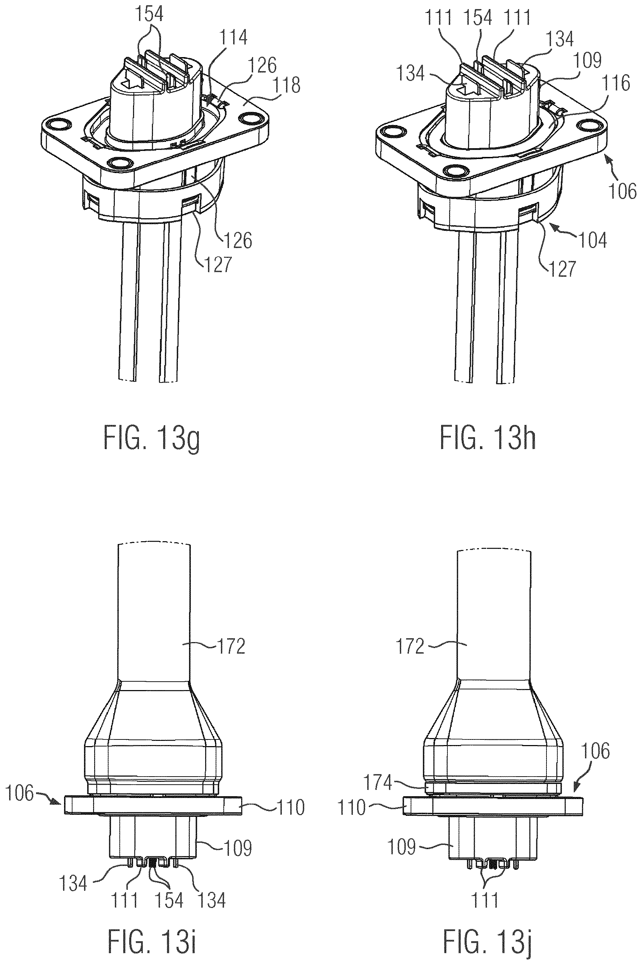

Bei dem Ausführungsbeispiel nach den Fig. 7 ff. wird ein Kabeldurchführungsgehäuse 102 durch eine Gehäusekappe 104 und einen einheitlichen Durchführungsgehäuse-Körper 106 gebildet, die im montierten Zustand miteinander verrastet sind. Der Durchführungsgehäuse-Körper 106 stützt ein Abschirmblech 108 über einen einteilig an dem Durchführungsgehäuse-Körper 106 ausgebildeten Flansch 110 ab, von dessen Vorderfläche ein Gehäusevorsprung 109 abragt, dessen Vorderfläche von Stegen 111 überragt ist (Figur 13h). Der Flansch 110 bildet eine Anlagefläche 112 zur Anlage gegen ein Steuergehäuse aus. Diese Anlagefläche 112 ist mit einer Nut 114 versehen, die einen Dichtring 116 in sich aufnimmt, der innerhalb des Abschirmblechs 108 vorgesehen ist (Figur 7). Hierzu ist eine mit Bezugszeichen 118 gekennzeichnete Abschirmfläche von einer mittleren Ausnehmung 120 durchsetzt, die den Dichtring 116 in der Anlagefläche 112 freilegt (vgl. Fig. 10). Darüber hinaus hat das Abschirmblech 108 die Abschirmfläche 118 durchsetzende ausgestanzte Löcher 122, die im montierten Zustand mit seitlichen Befestigungsbohrungen 124 fluchten, die Beispiele für Befestigungsmittel im Sinne der Erfindung darstellen und die an dem Flansch 110 ausgespart sind (vgl. Fig. 9, 10). Aus der die Abschirmfläche 118 enthaltenden Ebenen sind vier Kontaktstege 126 durch Stanzen und Biegen herausgebogen, die sich im Wesentlichen rechtwinklig zu der Abschirmfläche 118 erstrecken. Die Außenseite des Kontaktsteges 126 bildet hier eine Kontaktierungsfläche 126.1 aus. Zur Anlage der Kontaktstege 126 ist der Gehäusevorsprung 109 mit Anlagenstegen 125 versehen, die von der konvexen Umfangsfläche des Gehäusevorsprungs 109 vorstehen und von Rastnocken 127 überragt sind (Figur 9).

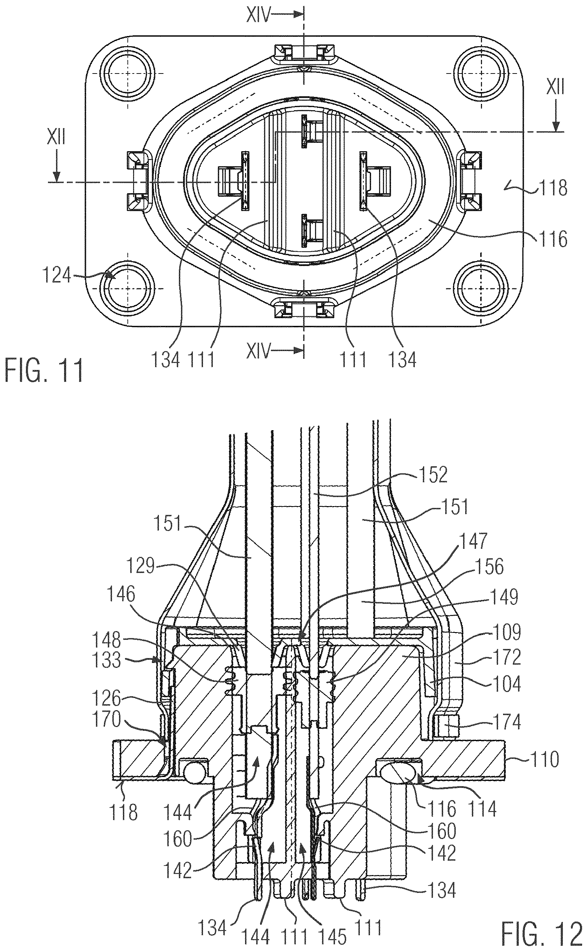

Die in Fig. 8 gezeigte Gehäusekappe 104 weist von einer Abdeckfläche 128 nach vorne vorspringende Vorsprünge 129 auf, die jeweils leicht federnd an der Abdeckfläche 128 angebunden und größeren Durchbrechungen 130 innerhalb der Abdeckfläche zugeordnet sind. Zwischen diesen größeren Durchbrechungen 130 ist die Abdeckfläche 128 ferner von kleineren Öffnungen 131 durchsetzt. Ein Kragen 132 der Gehäusekappe 104 weist am Umfang verteilt vier Rastöffnungen 133 auf, in den im gefügten Zustand die Rastnocken 127 verriegelt sind; vgl. Figur 12.

Die Kontaktelemente des zweiten Ausführungsbeispiels sind identisch zu den Kontaktelementen des ersten Ausführungsbeispiels ausgebildet und insgesamt mit Bezugszeichen 134, 135 und hinsichtlich ihrer Details mit den Bezugszeichen 136 bis 142 gekennzeichnet. Auf die Beschreibung zu Figur 4 wird verwiesen.

Der Durchführungsgehäuse-Körper 106 ist aus einem isolierenden Kunststoffmaterial hergestellt und hat vier den Durchführungsgehäuse-Körper 106 von vorne nach hinten durchsetzende Durchgänge, von denen die größeren Durchgänge mit den Bezugszeichen 144 und die kleineren Durchgänge mit Bezugszeichen 145 gekennzeichnet sind. Auf der in Fig. 9 zu erkennenden Rückseite sind die Durchgänge 144, 145 als Abdichtungsaufnahmen ausgebildet, die in den Fig. 9 und 11 als große Abdichtungsaufnahmen 146 und kleine Abdichtungsaufnahmen 147 gekennzeichnet sind. Diese Abdichtungsaufnahmen 146, 147 sind zur Aufnahme von größenmäßig angepassten großen und kleinen Kabelabdichtungselementen 148, 149 angepasst ausgebildet. Die jeweiligen Kabelabdichtungselemente 148, 149 haben eine Labyrinthdichtstruktur mit mehreren axial voneinander beabstandeten Dichtwulsten. Sie sind aus einem weich-elastischen Material hergestellt. Ihr Innendurchmesser ist an den Außendurchmesser eines Kabels angepasst, von denen die den Leistungsstrom leitenden Kabel mit Bezugszeichen 151 gekennzeichnet sind und die dem HV-Interlock-Kreis zugeordneten Kabel mit Bezugszeichen 152 gekennzeichnet sind. Die großen Kontaktelemente 134 sind an die HV-Leistungskabel 151 angeschlossen sind, die kleinen Kontaktelemente 135 an die HV Interlock-Kabel 152. Die Kabel 151, 152 haben einen Kabelmantel 156 und eine Ader 160. Sie haben im vorliegenden Ausführungsbeispiel keine separate Kabelabschirmung.

Wie Fig. 11 verdeutlicht, haben die Durchgänge 144, 145 jeweils an der Vorderseite zur Aufnahme der Kontaktelemente 134, 135 angepasste Kontaktaufnahmen 162. Die mit Bezugszeichen 164 gekennzeichneten kleinen Kontaktaufnahmen sind den Kontaktelementen 135 zu den HV-Interlock-Kabeln 152 zugeordnet. Diese Kontaktelemente 166 sind im Wesentlichen wie die Kontaktelemente 134 ausgebildet und haben ebenfalls innere und äußere Crimplaschen und eine freigestanzte Rastzunge zum Verriegeln in den Durchführungsgehäuse-Körper 106. Auch insofern kann auf die Beschreibung zu den Kontaktelementen 134 verwiesen werden.

Im montierten Zustand greifen die Vorsprünge 129 in die großen Abdichtungsaufnahmen 148 ein und wirken mit den dort vorgesehenen Kabelabdichtungselementen 152 zusammen, um diese innerhalb der Abdichtungsaufnahme 148 zu verpressen und die Abdichtungswirkung zu erhöhen. Solche Maßnahmen sind für die Abdichtung der kleinen Kabelabdichtungselemente 149 nicht erforderlich.

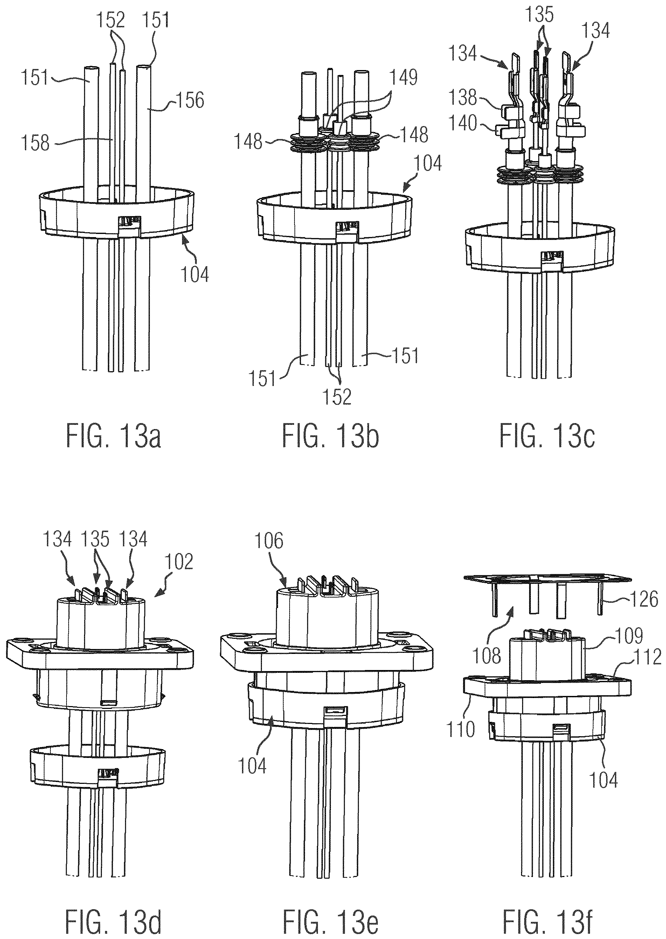

Zur Montage des Ausführungsbeispiels wird zunächst die Gehäusekappe 104 über die Kabel 151, 152 geschoben (Fig. 13a). Danach werden die Kabelabdichtungselemente 148, 149 über die Kabel 151, 152 geschoben (Fig. 13b). Nun werden die Kontaktelemente 134, 135 durch Vercrimpen mit dem Kabelmantel 156 der jeweiligen Kabel 151, 152 mechanisch über die äußere Crimplasche 140 und elektrisch über die innere Crimplasche 138 verbunden (Fig. 13c). Die Kontaktelemente 134, 135 werden nunmehr in den Durchführungsgehäuse-Körper 106 eingeschoben (Fig. 13d). Danach wird die Gehäusekappe 104 mit dem Durchführungsgehäuse-Körper verrastet (Fig. 13e). Von der gegenüberliegenden vorderen Seite wird nunmehr das Abschirmblech 108 über einen den Flansch 110 überragenden Gehäusevorsprung 109 des Durchführungsgehäuse-Körpers 106 geführt (Fig. 13f). Dabei durchsetzen die Kontaktstege 126 an dem Flansch 110 ausgesparte Kontaktsteg-Aufnahmen 170 und liegen schließlich an der Außenumfangsfläche des Gehäusevorsprungs 109 auf dem Umfang verteilt frei (vgl. Figuren 12, 13f). Die Abschirmfläche 118 bedeckt im Wesentlichen die Anlagefläche 112, die durch den Flansch 110 gebildet wird. Die Nut 114 bleibt aufgrund der mittleren Ausnehmung 120 frei (Fig. 13g). Nunmehr kann der Dichtring 116 eingelegt werden (Fig. 13h). Schließlich wird ein mit Bezugszeichen 172 gekennzeichnetes Abschirmgeflecht über den Gehäusevorsprung 109 gezogen, sodass die Innenumfangsfläche des Abschirmgeflechts 172 die Kontaktstege 126 umschließt (Fig. 13i). Ein mit Bezugszeichen 174 gekennzeichneter Kabelbinder fixiert das Abschirmgeflecht 172 gegen den Gehäusevorsprung 109 unter Einschluss und elektrischer Kontaktierung zwischen dem Abschirmgeflecht 172 und den Kontaktstegen 126. So ist eine von außen nach innen geführte Abschirmung innerhalb des Kabeldurchführungsgehäuses 2 vorgesehen (Figuren 12, 13j). An dem anderen Ende des Abschirmgeflechts 172 kann ein elektrischer Stecker zur Steckkontaktierung des Steuergehäuses vorgesehen sein, der unter Einschluss des Abschirmgeflechts 172 abgeschirmt ist.

Im montierten Zustand überragen die Kontaktelement 134, 135 die Vorderfläche des Gehäusevorsprungs 109. Zwischen den Kontaktelementen 134 für den HV-Leistungsstrom erstrecken sich die Stege 111.

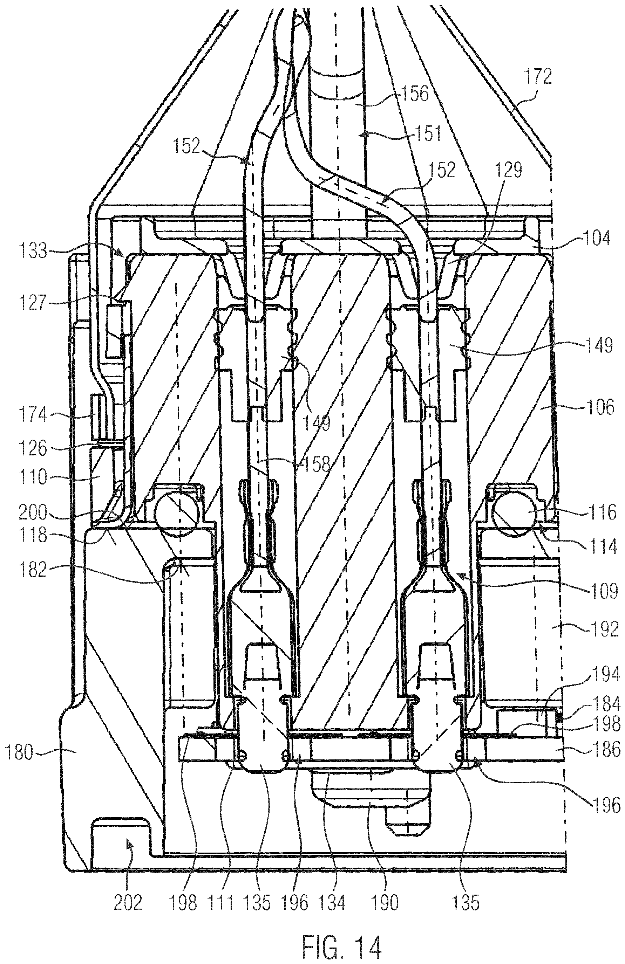

Die Figur 14 zeigt eine Schnittansicht entlang der Linie XIV - XIV gemäß der Darstellung in Figur 11 für die zuvor beschriebene Kabeldurchführung bei Montage an einem mit Bezugszeichen 180 gekennzeichneten Steuergehäuseelement, welches als metallische Gehäuseschale ausgebildet ist. Das Steuergehäuseelement 180 hat mehrere von einer Innenfläche 182 abragende Haltenocken 184, die üblicherweise in Eckbereichen des Steuergehäuseelementes 180 vorgesehen sind und eine Leiterplatte 186 abstützen, die mit verschiedenen Bauteilen 190 bestückt ist. Das Steuergehäuseelement 180 bildet ferner zumindest einen Kühlvorsprung 192 aus, an dem üblicherweise unter Zwischenlage einer elektrischen Isolierschicht ein Verlustleistung erzeugender Leistungsschalter 194 anliegt, der über die Leiterplatte 186 kontaktiert ist.

Die Leiterplatte 186 weist mehrere Ausnehmungen 196 auf, die mit weiblichen Kontaktelementen 198 bestückt sind, die in die Ausnehmung 196 hineinragende Federzungen haben und in EP 2 236 330 A1 beschrieben sind. Über diese weiblichen Kontaktelemente 198 sind die kleinen bzw. großen Kontaktelemente 134, 135 mit der Leiterplatte 186 kontaktiert. Dazu sind die jeweiligen Kontaktelemente 134, 135 - wie die Figur 14 belegt - durch die Ausnehmung 196 hindurch gesteckt und durchragen die Leiterplatte 186.

Bei dem gezeigten Ausführungsbeispiel befindet sich die Leiterplatte 186 mit geringem Abstand zu der vorderen Stirnfläche des Gehäusevorsprungs 109. Die Anordnung der Leiterplatte 186 mit Bezug auf die Abmessung des Steuergehäuseelementes 180 ist so gewählt, dass der entsprechende Spalt eingehalten ist, wenn der Flansch 110 unter Zwischenlage der Abschirmfläche 118 gegen eine Außenfläche 200 des Steuergehäuseelementes 180 anliegt, wodurch die äußere Abschirmung des Kabels über das Abschirmgeflecht 172 auf eine durch das metallische Steuergehäuseelement 180 gebildete Steuergehäuseabschirmung überführt wird.

Das Steuergehäuseelement 180 hat eine an dem freien Rand umlaufende Nut 202, in welche ein Vorsprung eines auf das Steuergehäuseelement 180 dichtend aufsetzbaren Gehäusedeckels einbringbar ist. Über in die Nut 202 eingebrachten elastischen Kleber kann eine Abdichtung zu dem Gehäusedeckel erfolgen, sodass die Leiterplatte 186 gegenüber Umwelteinflüssen geschützt in dem Steuergehäuse aufgenommen ist.

### Bezugszeichenliste

- 2: Kabeldurchführungsgehäuse
- 4: Durchführungsteil
- 6: Aufnahmeteil
- 8: Abschirmblech
- 10: Flansch
- 12: Anlagefläche
- 14: Nut
- 16: Dichtring
- 18: Abschirmfläche
- 20: mittlere Bohrung
- 22: weibliche Steckelementaufnahme
- 24: seitliche Befestigungsbohrung
- 26: Crimpsteg
- 28: erste Crimplasche
- 30: zweite Crimplasche
- 32: dritte Crimplasche
- 34: Kontaktelement
- 36: Kontaktzunge
- 38: innere Crimplasche
- 40: äußere Crimplasche
- 42: Rastzunge
- 44: Vorderfläche
- 46: Kabel
- 48: Steg
- 50: Bohrung
- 52: Klemmstift
- 54: Klemmstiftaufnahme
- 56: Kabelmantel
- 58: Kabeldichtelement
- 60: äußere Dichtfläche
- 62: Kabeldurchführungsöffnung
- 64: Aufnahmeraum
- 66: Kabelabschirmung
- 68: innerer Mantel
- 70: Ader
- 72: Schrumpfschlauchstück
- 74: Kontaktaufnahme
- 76: Vorbereitungen
- 102: Kabeldurchführungsgehäuse
- 104: Gehäusekappe
- 106: Durchführungsgehäuse-Körper
- 108: Abschirmblech
- 109: Gehäusevorsprung
- 110: Flansch
- 111: Steg
- 112: Anlagefläche
- 114: Nut
- 116: Dichtring
- 118: Abschirmfläche
- 120: mittlere Ausnehmung
- 122: Loch
- 124: Befestigungsbohrung
- 125: Anlagesteg
- 126: Kontaktsteg
- 126.1: Kontaktierungsfläche
- 127: Rastnocke
- 128: Abdeckfläche
- 129: Vorsprung
- 130: größere Durchbrechung
- 131: kleinere Öffnung
- 132: Kragen
- 133: Rastöffnung
- 134: große Kontaktelemente
- 135: kleine Kontaktelemente
- 136: Kontaktzunge
- 138: innere Crimplasche
- 140: äußere Crimplasche
- 142: Rastzunge
- 144: großer Durchgang
- 145: kleiner Durchgang
- 146: große Abdichtungsaufnahme
- 147: kleine Abdichtungsaufnahme
- 148: großes Kabelabdichtelement
- 149: kleines Kabelabdichtelement
- 151: HV-Leistungskabel
- 152: HV-Interlock-Kabel
- 156: Kabelmantel
- 158: Kabelmantel
- 160: Ader
- 162: große Kontaktaufnahme
- 164: kleine Kontaktaufnahme
- 170: Kontaktsteg-Aufnahme
- 172: Abschirmgeflecht
- 174: Kabelbinder
- 180: Steuergehäuseelement
- 182: Innenfläche
- 184: Haltenocken
- 186: Leiterplatte
- 190: Bauteil
- 192: Kühlvorsprung
- 194: Leistungsschalter
- 196: Ausnehmung
- 198: weibliches Kontaktelement
- 200: Außenfläche
- 202: Nut

## Patentansprüche

1. Steuervorrichtung in einem Kraftfahrzeug, insbesondere einer elektrischen Heizvorrichtung, mit einem Steuergehäuse (180), das eine Leiterplatte (186) umgibt, die mit weiblichen Steckkontaktelementen (198), bestückt ist, und einem dichtend an das Steuergehäuse (180) angelegten Kabeldurchführungsgehäuse (2, 102), das eine Anlagefläche (12, 112) und bevorzugt Befestigungsmittel (124) zur Befestigung des Durchführungsgehäuses (2, 102) an dem Steuergehäuse (180) aufweist und Aufnahmen (64; 144, 146) für zumindest zwei Kabel (46) aufweist, und mit von einer Vorderfläche (44) des Durchführungsgehäuses (2, 102) abragenden Kontaktelementen (34, 134), die zur Steckkontaktierung mit der Leiterplatte (186) angepasst ausgebildet und innerhalb des Durchführungsgehäuses (2, 102) mit den zugeordneten Kabeln (46) elektrisch verbunden sind, wobei die Kontaktelemente (34, 134) zum elektrischen Anschluss der Kabel (46) an die Leiterplatte (186) jeweils in einem der weiblichen Steckkontaktelemente (198) der Leiterplatte (186) aufgenommen sind,
**dadurch gekennzeichnet,**
**dass** von der Vorderfläche (44) zumindest ein sich zwischen zwei Kontaktelementen (34, 134) erstreckender elektrisch isolierender Steg (48, 111) abragt und dass die Leiterplatte (186) zwischen den weiblichen Steckkontaktelementen (198) eine korrespondierend zu dem Steg (48, 111) ausgebildete Stegaufnahme aufweist, in der der Steg (48, 111) aufgenommen ist.

2. Steuervorrichtung nach Anspruch 1, **dadurch gekennzeichnet, dass** das Kabeldurchführungsgehäuse (2, 102) einen die Anlagefläche (12, 112) ausbildenden Flansch (10,110) aufweist und in der Anlagefläche (12, 112) eine umlaufende Nut (14, 114) ausgespart ist, in der ein Dichtring (16, 116) aufgenommen ist.

3. Steuervorrichtung nach einem der vorherigen Ansprüche, **gekennzeichnet durch** ein Abschirmblech (8), das eine Abschirmfläche (18) zur Kontaktierung einer gehäuseseitigen Abschirmung (66) und zumindest zwei sich im Wesentlichen rechtwinklig hierzu erstreckende Crimpstege (26) ausformt, die mit den Kabeln (46) verbunden sind.

4. Steuervorrichtung nach Anspruch 3, **dadurch gekennzeichnet, dass** die Abschirmfläche (18) mit zumindest einer Bohrung versehen ist, die als Befestigungsaufnahmen (20, 24) oder weibliche Steckelementaufnahmen (22) einer elektrischen Steckverbindung angepasst ausgebildet ist.

5. Steuervorrichtung nach Anspruch 3 oder 4, **dadurch gekennzeichnet, dass** ein dichtend mit einem Kabelmantel (56) zusammenwirkendes Kabelabdichtelement (58) über eine einteilig an dem Crimpsteg (26) ausgebildete Crimplasche (32) mit dem Abschirmblech (8) verbunden ist.

6. Steuervorrichtung nach einem der vorherigen Ansprüche, **dadurch gekennzeichnet, dass** das Kabeldurchführungsgehäuse (2, 102) zweiteilig mit einem die Kontaktelemente (34, 134) haltenden Aufnahmeteil (6) und einem die Kabel (46) abdichtenden Durchführungsteil (4) ausgebildet ist und das dass Abschirmblech (8) zwischen dem Aufnahmeteil (6) und dem Durchführungsteil (4) gesichert ist.
